# EUROPEAN PATENT APPLICATION

(11) **EP 4 503 061 A1**
(43) Date of publication of application: **05.02.2025**
(21) Application number: 23780602.1
(22) Date of filing: 28.03.2023
(51) Int. Cl.: H01B 1/22, B22F 1/00, B22F 1/102, B22F 7/08, B22F 9/00, C09D 11/52, H01B 1/00, H01L 21/52

(54) **PASTE COMPOSITION AND COMPOSITE**

(30) Priority: 31.03.2022 JP 2022061189
(71) Applicant: Panasonic Intellectual Property Management Co., Ltd., Kadoma-shi, Osaka 571-0057 (JP)
(72) Inventor: KAWAMURA, Motoi, Kadoma-shi, Osaka 571-0057 (JP); HANABUSA, Kakeru, Kadoma-shi, Osaka 571-0057 (JP); KURACHI, Tsuyoshi, Kadoma-shi, Osaka 571-0057 (JP); MIYAZAKI, Kaori, Kadoma-shi, Osaka 571-0057 (JP); MARUO, Kohei, Kadoma-shi, Osaka 571-0057 (JP)
(74) Representative: Grünecker Patent- und Rechtsanwälte PartG mbB
(86) International application number: PCT/JP2023/012659
(87) International publication number: WO 2023/190593

(57) **Abstract**

The problem to be overcome by the present disclosure is to provide a paste composition with excellent pot life. A paste composition contains coated silver particles (A) having their surface coated with an alkylamine, a silver compound (B), a solvent (C), and an amine (D). The proportion of the coated silver particles (A) is equal to or greater than 80% by mass and equal to or less than 92% by mass.

## Description

### Technical Field

The present disclosure generally relates to a paste composition and a composite, and more particularly relates to a paste composition containing coated silver particles, a silver compound, and an amine and a composite formed out of the paste composition.

### Background Art

To mount a semiconductor chip on a board, a technique called "die bonding" is employed generally. According to the die bonding technique, a metallic powder paste interposed between a semiconductor chip and a board is sintered to form a bonding layer, with which the semiconductor chip is fixed onto the board.

Silver particles contained in a silver paste for use in the die bonding process generally have their surface coated with a modification group of an organic compound to reduce the chances of the silver particles aggregating together or being sintered at a low temperature. Patent Literature 1 discloses a sintered powder including particulates having a maximum average diameter less than 10 µm and formed by particles, at least some of which include a metal coated at least partially with a capping agent.

Such a paste composition for use in the die bonding process is required to have excellent pot life and to be storable for a long term. Patent Literature 1, however, fails to take pot life into consideration.

### Citation List

### Patent Literature

Patent Literature 1: JP 2015-536385 A

### Summary of Invention

A primary object of the present disclosure is to provide a paste composition with excellent pot life and a composite formed out of such a paste composition.

A paste composition according to an aspect of the present disclosure contains: coated silver particles (A) having their surface coated with an alkylamine; a silver compound (B); a solvent (C); and an amine (D). The proportion of the coated silver particles (A) is equal to or greater than 80% by mass and equal to or less than 92% by mass.

A composite according to another aspect of the present disclosure includes a base member, a member to be bonded, and a bonding layer interposed between the base member and the member to be bonded. The bonding layer includes a sintered body of the paste composition described above.

### Description of Embodiments

### 1. Overview

A paste composition according to an exemplary embodiment (hereinafter referred to as a "paste composition (X)") contains coated silver particles (A) having their surface coated with an alkylamine, a silver compound (B), a solvent (C), and an amine (D).

The present inventors carried out extensive research to overcome the problem described above. As a result, the present inventors discovered that such a paste composition (X) containing silver particles, a silver compound, and an amine could have its pot life extended by using, as the silver particles, coated silver particles, of which the surface was coated with an alkylamine, while maintaining a high bonding strength, thereby conceiving the concept of the present disclosure.

The reason why the paste composition (X) having such a structure may have its pot life extended is not perfectly clear at this time but is presumably as follows. Specifically, using, for the paste composition (X) containing an amine, a compound having an amino group as the same functional group as a surface coating agent for the silver particles would reduce change in the surface condition of the silver particles and thereby contribute to stabilizing the paste properties of the paste composition (X) including the coated silver particles (A) as its main component.

In addition, the paste composition (X) according to this embodiment may maintain a high bonding strength, i.e., may keep its bonding strength sufficiently high after the paste composition (X) has been subjected to the sintering process. Besides, the paste composition (X) has excellent printability as well.

The reason why the paste composition (X) having such a structure may keep its bonding strength sufficiently high even after having been subjected to sintering is not perfectly clear at this time but is presumably as follows. Specifically, using, as the silver particles, particular coated silver particles (A) that use an alkylamine as its surface coating agent enables increasing the proportion of the silver particles to a specific range. In addition, adding the amine (D) along with the solvent (C) would cause the silver compound (B) to be turned into a complex by the amine (D), which would allow the silver compound (B) to be dissolved in the solvent (C) and present with good stability. Increasing the proportion of the coated silver particles (A) and stabilizing the silver compound (B) in the paste composition allows the silver compound (B) to be present with good stability in the vicinity of the coated silver particles (A), thus producing nano-silver (i.e. silver nanoparticles) from the silver compound (B) uniformly around the coated silver particles (A) and ensuring a sufficient number of points of contact between the coated silver particles (A) and the silver nanoparticles. Consequently, this enables keeping the bonding strength sufficiently high after the paste composition (X) has been subjected to the sintering process.

As can be seen, the present disclosure enables providing a paste composition with excellent pot life and a composite formed out of such a paste composition.

### 2. Details

### <Paste composition>

A paste composition (X) according to this embodiment contains coated silver particles (A), a silver compound (B), a solvent (C) and an amine (D). Optionally, the paste composition (X) may further contain other components (E) unless the advantages of this embodiment are impaired.

Next, the respective components will be described one by one.

### [Coated silver particles (A)]

The coated silver particles (A) are silver particles, of which the surface is coated with an alkylamine as a surface coating agent. The "silver particles" as used herein refer to metallic particles, of which the main component is silver and of which at least a surface layer is made of silver. As used herein, the "main component" refers to a component with the largest content of the coated silver particles (A), and specifically refers to a component, of which the content is normally equal to or greater than 50% by mass and preferably equal to or greater than 70% by mass.

The coated silver particles (A) may be obtained by coating the surface of silver particles with an alkylamine. The "alkylamine" as used herein refers to an amine having an alkyl group. The alkylamine may have one alkyl group or two or more alkyl groups, whichever is appropriate. The alkylamine may be a monoamine, a diamine, or an amino alcohol, whatever is appropriate. Among other things, a monoamine is preferred. The number of carbon atoms included in the alkyl group is preferably equal to or greater than 3 and equal to or less than 20. Making the number of carbon atoms greater than 20 would inhibit sintering of the coated silver particles (A) due to steric hindrance of the alkylamine as the surface coating agent, thus possibly causing a decrease in electrical conductivity and bonding strength. The number of carbon atoms of the alkyl group is more preferably equal to or greater than 6 and equal to or less than 19, even more preferably equal to or greater than 10 and equal to or less than 18, and particularly preferably equal to or greater than 12 and equal to or less than 16. Setting the number of carbon atoms of the alkyl group included in the alkylamine at a value falling within any of these ranges enables further improving the thermal conductivity and bonding strength of a sintered body of the paste composition (X).

Examples of the alkyl group included in the alkylamine include a propyl group, a butyl group, a pentyl group, a hexyl group, an octyl group, a decyl group, a dodecyl group, a tetradecyl group, a hexadecyl group, an octadecyl group, and an icosyl group.

Examples of the alkylamine include ethylamine, hexylamine, heptylamine, octylamine, 2-ethylhexylamine, nonylamine, decylamine, dodecylamine, tetradecylamine, hexadecylamine, octadecylamine, and icosylamine. Among other things, dodecylamine is preferred.

The amount of the surface coating for the coated silver particles (A) is preferably equal to or greater than 0.5 parts by mass and equal to or less than 5 parts by mass with respect to 100 parts by mass of the silver particles, of which the surface is to be coated. Setting the amount of the surface coating for the silver particles at a value less than 0.5 parts by mass may cause a decrease in dispersibility. On the other hand, setting the amount of the surface coating at a value greater than 5 parts by mass may hardly cause an increase in the degree of sintering. The amount of the surface coating is more preferably equal to or less than 2.5 parts by mass and even more preferably equal to or less than 1.5 parts by mass. The amount of the surface coating may be measured by the weight loss in a thermogravimetric differential thermal analyzer in a nitrogen atmosphere.

The coated silver particles (A) preferably have a mean particle size equal to or greater than 50 nm and equal to or less than 500 nm. Setting the mean particle size of the coated silver particles (A) at a value less than 50 nm would cause an increase in their surface area and thereby cause an increase in the activity of the coated silver particles (A) so significantly as to advance sintering even at room temperature and thereby make it difficult to keep the silver paste stabilized in some cases. On the other hand, setting the mean particle size of the coated silver particles (A) at a value greater than 500 nm would cause a decrease in the surface area of the coated silver particles (A) and thereby slow down the sintering process significantly in some cases. As used herein, the "mean particle size" of the coated silver particles (A) refers to a particle size calculated based on a scanning electron microscope (SEM) photograph. The coated silver particles (A) more preferably have a mean particle size equal to or greater than 100 nm and equal to or less than 400 nm.

It is important that the proportion of the coated silver particles (A) is equal to or greater than 80% by mass and equal to or less than 92% by mass with respect to the paste composition (X). Setting the proportion of the coated silver particles (A) at a value less than 80% by mass would cause a decrease in the number of points of contact between the silver particles themselves or between the silver particles and the silver nanoparticles during the sintering process, thus causing such a significant delay in the sintering between the silver particles and the silver nanoparticles as to make the bonding strength between the sintered body and the chip insufficient. On the other hand, setting the proportion of the coated silver particles (A) at a value greater than 92% by mass would prevent other constituent materials from making the surface of the silver particles (A) wet, thus making it difficult to make the paste.

### [Silver compound (B)]

The silver compound (B) herein refers to a compound containing silver and is normally a compound having silver ions. The coated silver particles (A) are not included in the silver compound (B).

Examples of the silver compound (B) include silver salts and silver complexes.

Examples of the silver salts include: silver salts of monocarboxylic acids such as silver acetate, silver propionate, silver myristate, silver butyrate, silver neodecanoate, silver oleate, silver linoleate, silver caprylate, silver caprate, silver 2-methylpropanoate, silver 2-methylbutanoate, silver 2-ethylbutanoate, and silver 2-ethylhexanoate; and silver salts of carboxylic acids including silver salts of dicarboxylic acid such as silver oxalate.

Examples of the silver complex include a silver ethylenediamine complex.

The silver compound (B) preferably contains a silver salt, more preferably contains a silver salt of a carboxylic acid, even more preferably contains a silver salt of a monocarboxylic acid, and most preferably contains silver acetate. Adding any of these salts to the silver compound (B) enables further extending the pot life.

The proportion of the silver compound (B) is preferably equal to or greater than 0.2% by mass and equal to or less than 5% by mass with respect to the paste composition (X). Setting the proportion of the silver compound (B) at a value greater than 5% by mass would allow a salt, which is a byproduct produced when a complex of the silver compound (B) is formed, to affect the advancement of the sintering process adversely and thereby cause a decrease in the bonding strength in some cases. The proportion of the silver compound (B) is more preferably equal to or greater than 0.5% by mass and equal to or less than 3% by mass and even more preferably equal to or greater than 0.5% by mass and equal to or less than 1.5% by mass. Setting the proportion of the silver compound (B) at a value falling within any of these ranges enables further increasing the bonding strength.

### [Solvent (C)]

Any solvent may be used without limitation as the solvent (C) as long as the solvent (C) may be used to prepare the paste composition (X) in a paste form when mixed with constituent materials such as the coated silver particles (A). The solvent (C) preferably has a boiling point equal to or higher than 180°C. In that case, setting the boiling point of the solvent (C) at a temperature equal to or higher than 180°C reduces components that vaporize at an ordinary temperature, thus enabling reducing a variation in the solid content of the paste. Consequently, this enables maintaining the viscosity of the paste composition (X) stably at the time of printing.

Examples of the solvent (C) include alcohol solvents, glycol solvents, glycol ether solvents, acetate solvents, ketone solvents, hydrocarbon solvents, and mixed solvents thereof.

Examples of the alcoholic solvent include isopropyl alcohol, butanol, heptanol, octanol, decanol, lauryl alcohol, tetradecyl alcohol, cetyl alcohol, terpineol (with a boiling point of 217°C), dihydroterpineol, and isobornylcyclohexanol (with a boiling point of 300°C).

Examples of the glycol solvent include 2-ethyl-1,3-hexanediol (with a boiling point of 243°C), ethylene glycol (with a boiling point of 197°C), propylene glycol (with a boiling point of 188°C), diethylene glycol, dipropylene glycol, and 2,3-butanediol (with a boiling point of 182°C).

Examples of the glycol ether solvents include ethylene glycol monomethyl ether, ethylene glycol monoethyl ether, ethylene glycol monobutyl ether, diethylene glycol monomethyl ether, diethylene glycol monoethyl ether, diethylene glycol monobutyl ether, triethylene glycol monobutyl ether, propylene glycol monomethyl ether, and dipropylene glycol monomethyl ether.

Examples of the acetate solvent include butyl carbitol acetate.

Examples of the ketone solvent include methyl ethyl ketone, methyl isobutyl ketone, and isophorone.

Examples of the hydrocarbon solvent include decane, dodecane, and tetradecane.

The solvent (C) preferably contains a glycol solvent and more preferably contains 2-ethyl-1,3-hexanediol.

The proportion of the solvent (C) is preferably equal to or less than 10% by mass, more preferably equal to or less than 7% by mass, even more preferably equal to or less than 5% by mass, with respect to the paste composition (X). The lower limit of the proportion of the solvent (C) may be, without limitation, equal to or greater than 0.1% by mass, for example.

### [Amine (D)]

The amine (D) herein refers to a compound having an amino group (i.e., -NR₂, R=H, or a monovalent hydrocarbon group). The amine (D) would cause the silver compound (B) to be dispersed uniformly in the paste composition (X) by turning the silver compound (B) into a complex and thereby enable a sintered body having a dense structure to be formed.

Examples of the amine (D) include primary amines, secondary amines, tertiary amines, and amino alcohols, which are compounds each having both an amino group and a hydroxyl group. The amine (D) may be a monoamine or a diamine, whichever is appropriate.

Examples of the monoamine include:
primary amines such as 2-ethylhexylamine, hexylamine, heptylamine, octylamine, nonylamine, aminodecane, dodecylamine, tetradecylamine, cyclohexylamine, and aniline;
secondary amines such as dipropylamine, dibutylamine, and dihexylamine; and
tertiary amines such as tripropylamine and tributylamine.

Examples of the diamine include dimethylaminopropylamine, diethylaminopropylamine, and dibutylaminopropylamine.

Examples of the amino alcohol include 3-amino-1-propanol, 1-amino-2-propanol, N-methylethanolamine, 3-(dimethylamino)-1-propanol, monoethanolamine, diethanolamine, triethanolamine, N-methyldiethanolamine, and N- ethyldiethanolamine.

The amine (D) preferably includes at least one of a monoamine or an amino alcohol, more preferably includes an amino alcohol, and even more preferably includes 1-amino-2-propanol.

The proportion of the amine (D) is preferably equal to or greater than 0.5% by mass and equal to or less than 20% by mass with respect to the paste composition (X). Setting the proportion of the amine (D) at a value greater than 20% by mass would make it difficult to fill the gaps between the coated silver particles (A) during the sintering process, thus causing a decrease in bonding strength in some cases. The proportion of the amine (D) is more preferably equal to or greater than 1% by mass and equal to or less than 10% by mass, and even more preferably equal to or greater than 1.5% by mass and equal to or less than 5% by mass. Setting the proportion of the amine (D) at a value falling within any of these ranges enables further increasing the bonding strength.

### [Other components (E)]

Examples of other components (E) include dispersants. If the paste composition (X) contains the other components (E), the proportion of the other components (E) may be, for example, equal to or less than 1% by mass, and is preferably equal to or less than 5% by mass, with respect to the paste composition (X).

### <Method for preparing paste composition>

The paste composition (X) may be prepared by, for example, mixing together the solvent (C), the amine (D), and the other components (E) as needed, and kneading a mixed solution, prepared by dissolving the silver compound (B) in the mixture thus obtained, with the coated silver particles (A). Any general kneading method may be used without limitation for kneading the coated silver particles (A) with the mixed solution. For example, after having been stirred up with a planetary stirrer or a planetary centrifugal mixer, for example, the coated silver particles (A) and the mixed solution may be kneaded with a three-roll mill, for example.

### <Composite>

A composite according to this embodiment (hereinafter referred to as a "composite (Y)") includes a base member, a member to be bonded, and a bonding layer. The bonding layer is interposed between the base member and the member to be bonded. The bonding layer includes a sintered body of the paste composition (X). The composite (Y) is formed out of the above-described paste composition (X), and therefore, may achieve a high bonding strength.

The base member may be, for example, a wiring board. Specific examples of the base member include a motherboard, a package board, and an interposer board. The member to be bonded may be, for example, a semiconductor chip. More specifically, the member to be bonded may be a bare chip (die).

### <Method for fabricating composite>

The composite (Y) may be fabricated by, for example, printing the paste composition (X) onto the base member and prebaking the paste composition (X) to vaporize the solvent, mounting the member to be bonded (such as a semiconductor chip; i.e., making chip mounting) onto the paste composition (X) thus printed, and then sintering the assembly thus formed.

Any chip mounting method may be adopted without limitation; the chip mounting may be carried out with or without pressure applied and/or with ultrasonic vibrations applied.

Any general sintering process technique may also be adopted without limitation; the process may be a continuous process or a batch process, whichever is appropriate. Examples of the heating temperature profile of the sintering process include: (a) raising the temperature from room temperature to 250°C at a temperature increase rate of about 3.5°C/s and then maintaining the temperature at 250°C for an hour and (b) raising the temperature from room temperature to about 350°C at a temperature increase rate of about 1.5°C/s, maintaining the temperature at about 350°C for 30 seconds, and then lowering the temperature at a cooling rate equal to or higher than 2°C/s.

### (Recapitulation)

As can be seen from the foregoing description, the exemplary embodiment and its variations described above are specific implementations of the following aspects of the present disclosure.

A paste composition (X) according to a first aspect contains: coated silver particles (A) having their surface coated with an alkylamine; a silver compound (B); a solvent (C); and an amine (D). The proportion of the coated silver particles (A) is equal to or greater than 80% by mass and equal to or less than 92% by mass.

The first aspect allows the paste composition (X) to have excellent pot life.

In a paste composition (X) according to a second aspect, which may be implemented in conjunction with the first aspect, the number of carbon atoms of an alkyl group included in the alkylamine is equal to or greater than 3 and equal to or less than 20.

The second aspect may further improve the thermal conductivity and bonding strength of a sintered body of the paste composition (X) by setting the number of carbon atoms of the alkyl group included in the alkylamine at a value falling within this range.

In a paste composition (X) according to a third aspect, which may be implemented in conjunction with the first or second aspect, the silver compound (B) includes a silver salt of a carboxylic acid.

The third aspect may further extend the pot life of the paste composition (X).

In a paste composition (X) according to a fourth aspect, which may be implemented in conjunction with any one of the first to third aspects, the proportion of the silver compound (B) is equal to or greater than 0.2% by mass and equal to or less than 5% by mass, and the proportion of the amine (D) is equal to or greater than 0.5% by mass and equal to or less than 20% by mass.

The fourth aspect may further improve the bonding strength.

In a paste composition (X) according to a fifth aspect, which may be implemented in conjunction with any one of the first to fourth aspects, the solvent (C) has a boiling point equal to or higher than 180°C.

The fifth aspect allows the paste composition (X) to maintain a stabilized viscosity at the time of printing.

A composite (Y) according to a sixth aspect of the present disclosure includes a base member, a member to be bonded, and a bonding layer interposed between the base member and the member to be bonded. The bonding layer includes a sintered body of the paste composition according to any one of the first to fifth aspects.

The sixth aspect enables providing a composite (Y) having excellent bonding strength by fabricating the composite (Y) using the paste composition (X) described above.

### Examples

Next, the present disclosure will be described in further detail by way of illustrative examples. Note that the examples to be described below are only examples of the present disclosure and should not be construed as limiting.

### 1. Preparation of paste composition

A paste composition (X) was prepared using coated silver particles (A), a silver compound (B), and an amine (D), of which the respective amounts were as shown in the following Table 1, and a solvent (C), of which the amount had been adjusted to make the total of all components equal to 100% by mass.

The coated silver particles (A) were produced in the following manner.

In Example 1, a silver powder with a mean particle size of 15 µm was used as a material powder. The mean particle size of the silver powder was a value measured with a particle size analyzer. As the particle size analyzer, "MT3300" manufactured by MicrotracBEL Corporation was used.

The manufacturing conditions for the coated silver particles (A) were determined such that the input to a plasma was fixed at a constant value and the pressure inside a plasma torch was kept constant after having been reduced. An argon gas was used as a carrier gas, and an argon gas and a hydrogen gas were used as plasma gases and were supplied at fixed flow rates.

Next, a solution that had been prepared using dodecylamine as a surface treatment agent and ethanol as a solvent was sprayed onto the silver powder (primary fine particles) using an atomizing gas. An argon gas was used as the atomizing gas. In addition, an argon gas was supplied as a temperature adjustment gas from a gas supply tube provided upstream of the solution spraying point.

The coated silver particles (A) thus obtained were observed through a scanning electron microscope (SEM) (JSM-7800F manufactured by JEOL Ltd.) at a zoom power of 30,000 to capture an SEM image. In the SEM image thus shot, the mean particle size of more than 100 arbitrary coated silver particles (A) was measured to be about 200 nm.

In Examples 2-5 and Comparative Examples 1-3, the coated silver particles (A) were produced in the same way as in Example 1 except that a surface coating agent shown in the following Table 1 was used.

Silver acetate (manufactured by FUJIFILM Wako Pure Chemical Corporation) was used as the silver compound (B).

As the solvent (C), 2-ethyl-1,3-hexanediol (manufactured by FUJIFILM Wako Pure Chemical Corporation) was used.

As the amine (D), 1-amino-2-propanol (manufactured by FUJIFILM Wako Pure Chemical Corporation) was used.

First, the solvent (C) and the amine (D) were mixed, and the silver compound (B) was dissolved in the mixture to obtain a silver compound solution (hereinafter also referred to as a "silver compound solution (α)"). A paste composition (X) was prepared by kneading this silver compound solution (α) and the coated silver particles (A) with each other.

### 2. Fabrication of composite

A silver-plated direct bonded copper (DBC) board (manufactured by Hirai Seimitsu Kogyo Co., Ltd.) was provided as the base member. The paste composition (X) prepared as described above was printed on the surface of the base member by screen printing method to have dimensions of 2.7 mm × 2.7 mm in plan view and a thickness of 0.9 mm. The base member on which this paste composition (X) had been printed was placed on a hot plate and heated at 40°C for 15 minutes to be prebaked. A 2.5 mm silver-plated Cu chip (manufactured by Hirai Seimitsu Kogyo Co., Ltd.) was provided as the member to be bonded. A laminate consisting of the base member, the paste composition (X), and the member to be bonded was fabricated using these members and materials. This laminate was maintained at 250°C for 60 minutes to sinter the paste composition (X) and thereby form a bonding layer. A composite (Y) including the base member, the bonding layer, and the member to be bonded was fabricated in this manner.

### 3. Evaluation

The paste composition thus prepared was graded by (1) paste formation evaluation, (2) printability evaluation, and (3) pot life evaluation. The paste composition was further subjected to (4) initial shear strength evaluation and (5) post-thermal-shock-test shear strength evaluation to evaluate the paste composition in terms of its bonding strength.

### (1) Paste formation evaluation

The paste formation evaluation was carried out in the following manner. If the paste composition (X) could be prepared into the paste form, then the sample was graded "A." On the other hand, if the paste composition (X) could not be prepared into the paste form, then the sample was graded "B." In Comparative Example 3, the silver compound (B) could not be dissolved in the mixed solution of the solvent and the amine. The paste compositions according to Comparative Examples 2 and 3 could not be prepared into the paste form, and therefore, were not subjected to any of the evaluations (2) to (5). Thus, in Table 1, the results of evaluation for these comparative examples are indicated as "- (not available)."

### (2) Printability evaluation of paste composition

The printability evaluation was carried out on the paste composition in the following manner. If the paste composition (X) formed by screen printing method had no chipping in its pattern, then the sample was graded "A." On the other hand, if the paste composition (X) had any chipping in its pattern, then the sample was graded "B."

### (3) Pot life evaluation of paste composition

The paste composition (X) prepared as described above was left at room temperature for one week. The paste composition had its viscosity measured before and after having been left, thereby calculating the rate of change in viscosity before and after the paste composition had been left. The viscosity was measured using "RC-215U/RE-215U (rotor: SPP)" manufactured by Toki Sangyo Co., Ltd.

The room temperature storage stability of the paste composition was evaluated in the following manner. Specifically, if the viscosity change rate before and after the paste composition had been left fell within ±50%, then the sample was graded "A." On the other hand, if the viscosity change rate before and after the paste composition had been left fell outside of the range of ±50%, then the sample was graded "B."

### (4) Initial shear strength evaluation

As for the composite (Y) fabricated as described above, the shear strength (MPa) between the member to be bonded (e.g., a silver-plated Cu chip) and the base member (e.g., a silver-plated DBC board) was measured using 4,000 universal bond tester (manufactured by Nordson Corporation).

The measured values of the initial shear strength are shown in the following Table 1.

### (5) Post-thermal-shock-test shear strength evaluation

The composite (Y), of which the initial shear strength had been measured as described above, was exposed to an atmosphere at -40°C for 5 minutes, and then the composite was exposed to an atmosphere at 175°C for 5 minutes in one cycle. This process was repeated in 1000 cycles. As for the composite (Y) that had been subjected to the test in 1000 cycles, the shear strength (MPa) was measured again.

The measured values of the post-thermal-shock-test shear strength are shown in the following Table 1.

### Comprehensive evaluation

If the results of the (1) paste formation evaluation, (2) printability evaluation, and (3) pot life evaluation were all "A," the initial shear strength turned out to be equal to or greater than 30 MPa as a result of the evaluation (4), and the post-thermal-shock-test shear strength turned out to be equal to or greater than 20 MPa as a result of the evaluation (5), then the comprehensive evaluation of the sample was "A." On the other hand, if at least one of the results of the evaluations (1) to (3) was "B," the initial shear strength turned out to be less than 30 MPa as a result of the evaluation (4), or the post-thermal-shock-test shear strength turned out to be less than 20 MPa as a result of the evaluation (5), then the comprehensive evaluation of the sample was "B."

**[Table 1]**

| | Ex.1 | Ex.2 | Ex.3 | Ex.4 | Ex.5 | Cmp.Ex.1 | Cmp.Ex2 | Cmp.Ex.3 |
|---|---|---|---|---|---|---|---|---|
| Surface coating agent | Dodecyl amine | Dodecyl amine | Hexadecyl amine | Dodecyl Amine | Dodecyl amine | Citric acid | Citric acid | Dodecyl Amine |
| Coated silver particles (A) (% by mass) | 85 | 90 | 90 | 80 | 92 | 85 | 90 | 90 |
| Silver compound (B) (% by mass) | 1.3 | 1.3 | 1.3 | 1.3 | 1.3 | 1.3 | 1.3 | 1.3 |
| Amine (D) (% by mass) | 3 | 2 | 2 | 3 | 2 | 3 | 2 | 0 |
| (1) Paste formation evaluation | A | A | A | A | A | A | B | B (Silver compound Non-dissolvable) |
| (2) Printability evaluation | A | A | A | A | A | A | - | - |
| (3) Pot life evaluation | A | A | A | A | A | B | - | - |
| (4) Initial shear strength evaluation (MPa) | 40 | 50 | 30 | 35 | 55 | 40 | - | - |
| (5) Post-thermal-shock-test shear strength evaluation (MPa) | 30 | 40 | 20 | 25 | 45 | 30 | - | - |
| Comprehensive evaluation | A | A | A | A | A | B | B | B |

As can be seen from the results shown in Table 1, the paste compositions according to Examples 1-5 had not only excellent pot life but also excellent printability and bonding strength as well. On the other hand, the paste composition according to Comparative Example 1 had inferior pot life. Furthermore, neither of the paste compositions according to Comparative Examples 2 and 3 could be prepared into the paste form.

## Claims

1. A paste composition containing: coated silver particles (A) having their surface coated with an alkylamine; a silver compound (B); a solvent (C); and an amine (D),
proportion of the coated silver particles (A) being equal to or greater than 80% by mass and equal to or less than 92% by mass.

2. The paste composition of claim 1, wherein
a numerical number of carbon atoms of an alkyl group included in the alkylamine is equal to or greater than 3 and equal to or less than 20.

3. The paste composition of claim 1, wherein
the silver compound (B) includes a silver salt of a carboxylic acid.

4. The paste composition of claim 1, wherein
proportion of the silver compound (B) is equal to or greater than 0.2% by mass and equal to or less than 5% by mass, and
proportion of the amine (D) is equal to or greater than 0.5% by mass and equal to or less than 20% by mass.

5. The paste composition of claim 1, wherein
the solvent (C) has a boiling point equal to or higher than 180°C.

6. A composite comprising a base member, a member to be bonded, and a bonding layer interposed between the base member and the member to be bonded,
the bonding layer including a sintered body of the paste composition of any one of claims 1 to 5.
